# EUROPEAN PATENT APPLICATION

(11) **EP 4 637 286 A1**
(43) Date of publication of application: **22.10.2025**
(21) Application number: 25169845.2
(22) Date of filing: 10.04.2025
(51) Int. Cl.: H05K 7/20

(54) **HIGH POWER DENSITY DATA CENTER BLOCK SYSTEM**

(30) Priority: 19.04.2024 US 202463636445 P; 03.04.2025 US 202519169770
(71) Applicant: Vertiv Corporation, Westerville, OH 43082 (US)
(72) Inventor: Radanovic , Branislav, Westerville, 43082 (US); Brzic , Vedran, Westerville, 43082 (US)
(74) Representative: Cousens, Nico

(57) **Abstract**

A High Power Density (HPD) data center block system includes one or more HPD blocks. Each HPD block may include at least two rack rows including a first rack row arranged a select distance from a second rack row to form a hot aisle. Each HPD block may further include at least two air handling unit (AHU) devices. Each AHU device may be configured to directly distribute cool air to a plurality of racks. Each HPD block may further include one or more busbars arranged adjacent to the first rack row and the second rack row. The one or more busbars may be configured to provide power to the plurality of racks of the first rack row and the second rack row.

## Description

The present application claims the benefit under 35 U.S.C. § 119(e) of U.S. Provisional Application. No. 63/636,445, filed April 19, 2024.

### TECHNICAL FIELD

The present disclosure generally relates to the field of cooling systems, and more particularly, to a high power density (HPD) data center block system.

### BACKGROUND

Artificial intelligence (Al) models require training. Training is often performed in high performance data centers. Due to high power density (HPD) of the server racks in such data centers, requirements on power and cooling architecture are extreme in comparison to traditional data centers. Power and cooling architecture of traditional data centers do not allow for fast switch to High power density (HPD) data centers on a large scale. Therefore, there is a need for a system and method to provide flexibility in deployment for various climates, support various cooling technologies, and be quickly deployable and sustainable.

### SUMMARY

A data center system is disclosed, in accordance with one or more embodiments of the present disclosure. In embodiments, the data center system includes an enclosure including a plurality of sidewalls that define a cavity. In embodiments, the data center system includes one or more High Power Density (HPD) blocks housed within the cavity of the enclosure. In embodiments, each HPD block includes at least two rack rows including at least a first rack row and a second rack row, where the first rack row is arranged a select distance from the second rack row to form a hot aisle, where each rack row includes a plurality of racks. In embodiments, each HPD block includes at least two air handling unit (AHU) devices including at least a first AHU device arranged on a first end of the HPD block and a second AHU device arranged on a second end of the HPD block, where each AHU device is configured to directly distribute cool air to the plurality of racks of the at least two rack rows. In embodiments, each HPD block includes one or more busbars arranged adjacent to the first rack row and the second rack row, the one or more busbars configured to provide power to the plurality of racks of the first rack row and the second rack row, where the one or more busbars are arranged in the hot aisle.

A High Power Density (HPD) block system is disclosed, in accordance with one or more embodiments of the present disclosure. In embodiment, the HPD block system includes at least two rack rows including at least a first rack row and a second rack row, where the first rack row is arranged a select distance from the second rack row to form a hot aisle, where each rack row includes a plurality of racks. In embodiment, the HPD block system includes at least two air handling unit (AHU) devices including at least a first AHU device arranged on a first end of the HPD block and a second AHU device arranged on a second end of the HPD block, where each AHU device is configured to direct cool air to the plurality of racks. In embodiment, the HPD block system includes one or more busbars arranged adjacent to the first rack row and the second rack row, the one or more busbars configured to provide power to the plurality of racks of the first rack row and the second rack row, where the one or more busbars are arranged in the hot aisle.

A data center system is disclosed, in accordance with one or more embodiments of the present disclosure. In embodiments, the data center system includes an enclosure including a plurality of sidewalls that define a cavity. In embodiments, the data center system includes a plurality of High Power Density (HPD) blocks housed within the cavity of the enclosure, the plurality of HPD blocks including at least a first HPD block and a second HPD block, where the first HPD block is arranged adjacent to a surface of the second HPD block. In embodiments, each HPD block includes at least two rack rows including at least a first rack row and a second rack row, where the first rack row is arranged a select distance from the second rack row to form a hot aisle, where each rack row includes a plurality of racks. In embodiments, each HPD block includes at least two air handling unit (AHU) devices including at least a first AHU device arranged on a first end of the HPD block and a second AHU device arranged on a second end of the HPD block, where each AHU device is configured to directly distribute cool air to the plurality of racks. In embodiments, each HPD block includes one or more busbars arranged adjacent to the first rack row and the second rack row, the one or more busbars configured to provide power to the plurality of racks of the first rack row and the second rack row, where the one or more busbars are arranged in the hot aisle. In embodiments, each HPD block includes an exchangeable AHU device arranged proximate to at least one AHU device of the at least two AHU devices, where the exchangeable AHU device is configured to be switched out with a coolant distribution unit to provide direct-to-chip liquid cooling.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

The numerous advantages of the disclosure may be better understood by those skilled in the art by reference to the accompanying figures.
FIG. 1A is a simplified block diagram of a High Power Density (HPD) data center block system, in accordance with one or more embodiments of present disclosure.
FIG. 1B is a simplified schematic view of the HPD data center block system, in accordance with one or more embodiments of present disclosure.
FIG. 1C is a simplified schematic view of the HPD data center block system, in accordance with one or more embodiments of present disclosure.
FIG. 1D is a simplified schematic view of the HPD data center block system, in accordance with one or more embodiments of present disclosure.
FIG. 1E is a perspective view of the HPD data center block system, in accordance with one or more embodiments of present disclosure.
FIG. 1F is a perspective view of the HPD data center block system, in accordance with one or more embodiments of present disclosure.
FIG. 1G is a perspective view of the HPD data center block system, in accordance with one or more embodiments of present disclosure.
FIG. 2 is a cross-sectional view of an air handling unit (AHU) device of the HPD data center block system, in accordance with one or more embodiments of present disclosure.

### DETAILED DESCRIPTION

Reference will now be made in detail to the subject matter disclosed, which is illustrated in the accompanying drawings.

Embodiments of the present disclosure are directed to a High Power Density (HPD) data center block system. More particularly, the present disclosure is directed to an HPD data center block system including an enclosure configured to house one or more HPD blocks including at least two rack rows, one or more air handling unit (AHU) devices, and one or more busbars. For example, the data center setup may be configured to house one or more components of the HPD data center block system, where the at least two AHU devices circulate fresh air to the at least two racks including supporting data center equipment.

The HPD data center block system may provide a number of benefits/advantages. For example, the one or more AHU devices of the system may provide an optimized form factor to maximize cooling capacity within a given amount of available space. By way of another example, the system may lower mechanical partial power usage effectiveness (pPUE) through optimal rack and cooling units' layout and mechanical and electrical component selection. By way of another example, the system may simplify scalability due to the ability to adjust the number of HPD blocks based on customer's needs. Further, the system may allow for flexibility on cooling solution, as discussed further herein with respect to the air handling unit (AHU) devices. Additionally, the system may allow for optimized cooling efficiency due to the symmetrical configuration of the components and redundancy. By way of another example, the system may allow for rapid manufacturing and deployment due to the all-in-one modular system.

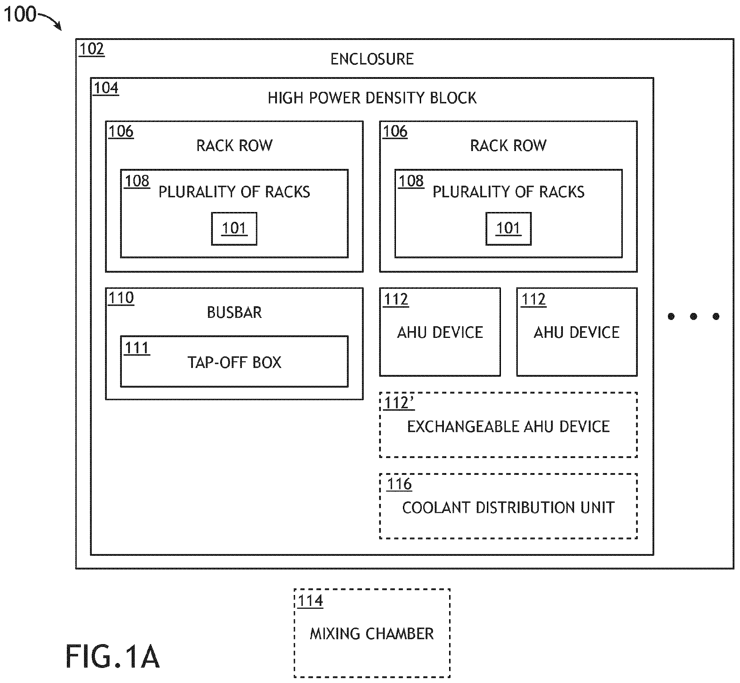

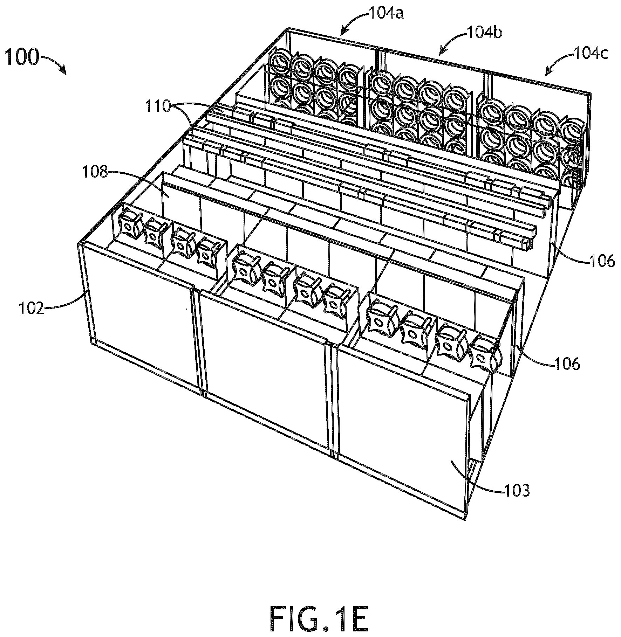

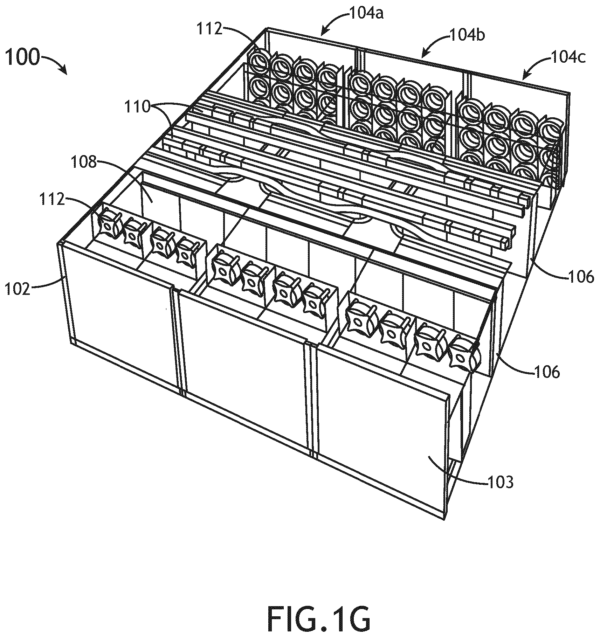

FIGS. 1A-1G illustrate the HPD data center block system 100 of the present disclosure, in accordance with one or more embodiments of the present disclosure. For purposes of the present disclosure, the term "high power density data center block system 100", "HPD data center block system 100", "HPD block system 100", "system 100", and variations thereof may be considered equivalent, unless otherwise noted herein.

In embodiments, the system 100 includes an enclosure 102 configured to house one or more components of the system 100. For example, the enclosure 102 may be configured to house one or more HPD blocks 104. By way of another example, the enclosure 102 may be configured to house equipment (e.g., supporting data center equipment, or the like).

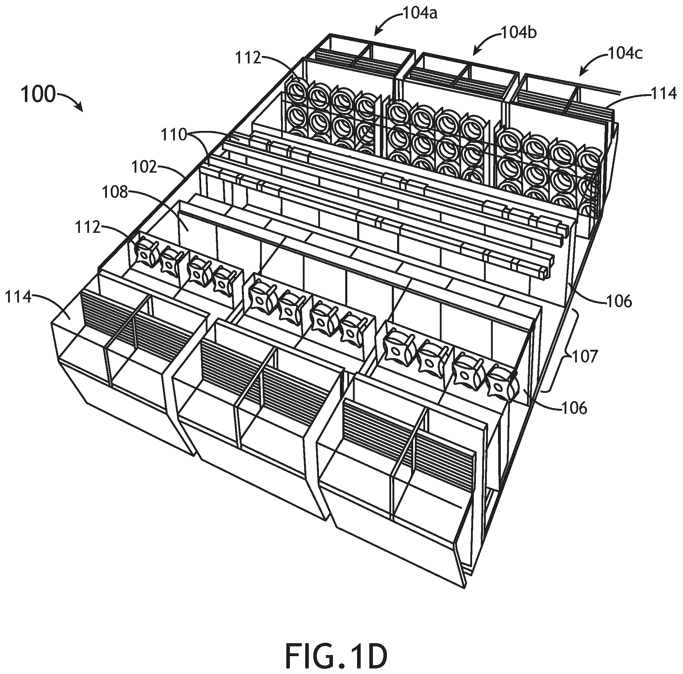

The enclosure 102 may be formed of a plurality of sidewalls 103 that define at least one cavity configured to house the one or more HPD blocks 104 (as shown in FIGS. 1D-1F). In a non-limiting example, the enclosure 102 may include an outdoor enclosure 102. For instance, the outdoor enclosure 102 may be installed on a roof (or mezzanine).

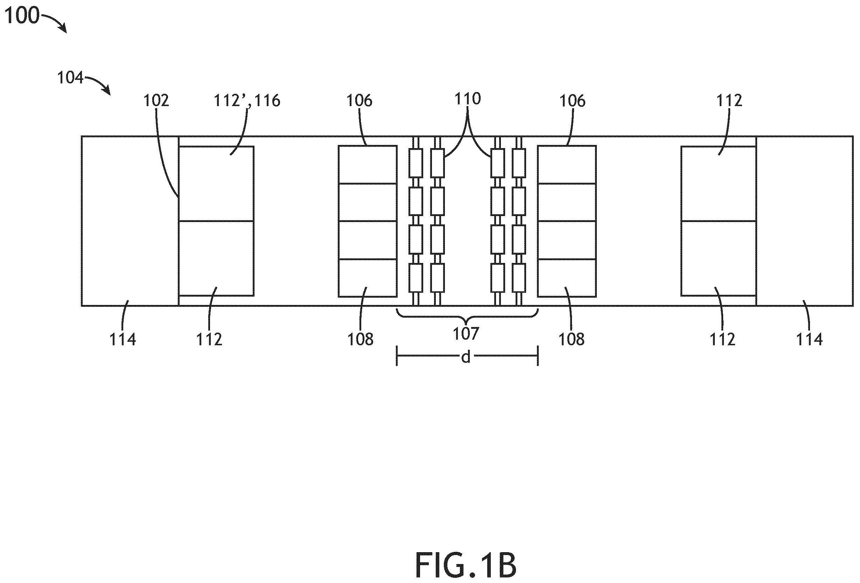

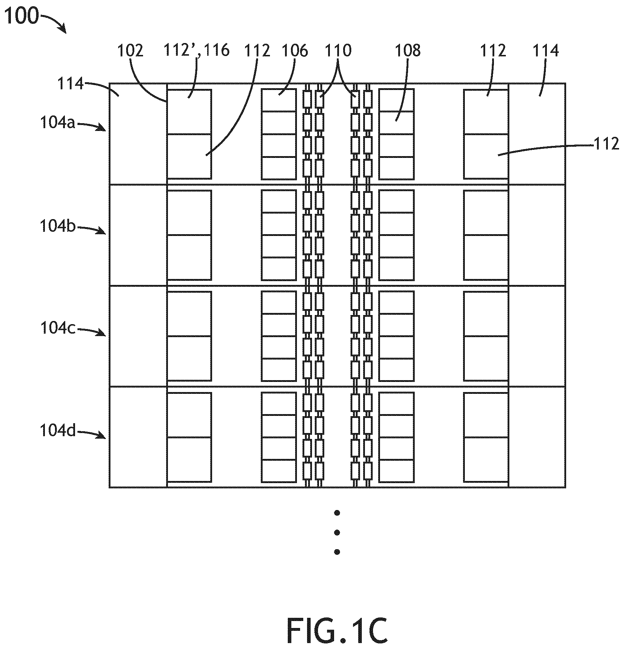

The system 100 may include any number of HPD blocks 104. For example, as shown in FIG. 1B, the system 100 may include a single HPD block 104. By way of another example, as shown in FIG. 1C, the system 100 may include a plurality of HPD blocks 104 repeatedly connected along the length of the HPD block 104. In a non-limiting example, as shown in FIG. 1C, the system 100 may include at least a first HPD block 104a, a second HPD block 104b, a third HPD block 104c, a fourth HPD block 104d, and up to an N number of HPD blocks (where N is an integer). In an additional non-limiting example, as shown in FIGS. 1D-1G, the system 100 may include three HPD blocks 104a, 104b, 104c, where the first HPD block 104a may be arranged adjacent a surface of the second HPD block 104b and the second HPD block 104b may be arranged adjacent a surface of the third HPD block 104c.

Referring to FIGS. 1A-1B, each HPD block 104 may include at least two rack rows 106. For example, the at least two rack rows 106 may include at least a first rack row arranged parallel to a second rack row. For instance, the first rack row may be positioned a predetermined distance d from the second rack row.

The distance d between the first rack row and the second rack row may form a hot aisle 107. For example, the length (or width) of the hot aisle 107 may correspond to the predetermined distance d between the at least two rack rows 106. The hot aisle 107 may be an area where the hot exhaust air from the racks 108 (and other equipment) is collected and directed back to a cooling system (as will be discussed further herein). It is contemplated herein that the predetermined distance d between the at least two rack rows 106 may be based on a minimum distance for serviceability and power distribution.

Although FIG. 1B depicts a specific configuration of the at least two rack rows 106, it is contemplated herein that each HPD block 104 may include any suitable configuration of the at least two rack rows 106.

Each rack row 106 of the at least two rack rows may include a plurality of racks 108. For example, as shown in FIG. 1B, each rack row 106 may include four racks 108 arranged in a row configuration. Although FIG. 1B depicts a specific configuration (e.g., number, arrangement, type, or the like) of racks 108, it is contemplated herein that each rack row 106 may include any suitable configuration of racks 108. In a non-limiting example, the racks 108 may include High Power Density equipment 101. For instance, the racks 108 may include, but are not limited to, high-performance servers, graphic processing units (GPUs), power management systems (e.g., power distribution units (PDUs), universal power systems (UPSs), and the like), cooling systems, and the like.

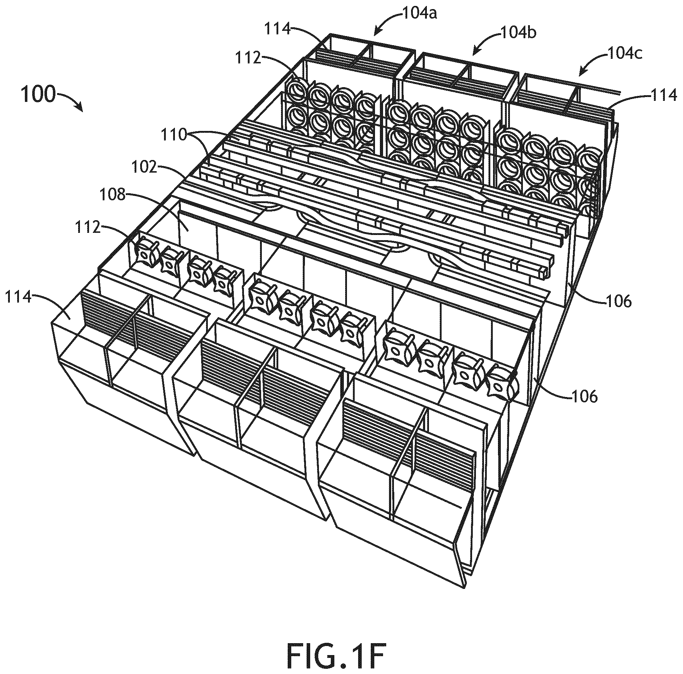

Each HPD block 104 may include one or more busbars 110 configured to provide power to the racks 108 of the at least two rack rows 106. For example, as shown in FIG. 1F, the one or more busbars 110 may be installed below a ceiling within the hot aisle 107 between the at least two rack rows 106.

In embodiments, the one or more busbars 110 include a single busbar arranged between the first rack row 106 and the second rack row 106. For example, the single busbar may be configured to supply power to the plurality of racks 108 in both the first row 106 and the second row 106.

In embodiments, the one or more busbars 110 include a set of busbars including at least two or more busbars. For example, at least a first busbar of the one or more busbars 110 may be arranged proximate to the first rack row 106 and configured to provide power to the racks 108 of the first rack row 106. By way of another example, a second busbar of the one or more busbars 110 may be arranged proximate to the second rack row 106 and configured to provide power to the racks 108 of the second rack row 106.

The one or more busbars 110 may include one or more tap-off boxes 111. The one or more tap-off boxes 111 may allow distribution of power from the respective busbar 110 to the plurality of racks 108. It is contemplated herein that the one or more tap-off boxes may be arranged in any suitable location such as, but not limited to, under the ceiling, in front of the racks 108, directly above the racks 108, behind the racks 108, or the like.

Each HPD block 104 may include at least two air handling unit (AHU) devices 112. For example, the at least two AHU devices 112 may include at least a first AHU device 112 arranged in a first end of the HPD block 104 (e.g., a left end) and at least a second AHU device 112 arranged in a second end of the HPD block 104 (opposite the first end) (e.g., a right end). In a non-limiting example, as shown in FIG. 1B, the first end of the HPD block 104 (e.g., the left end) may include two AHU devices 112, where one of the AHU devices 112 may be capable of being swapped out (as will be discussed herein). Continuing with the example, the second end of the HPD block 104 (e.g., the right end) may include two additional AHU devices 112.

Air handling unit (AHU) devices are generally discussed in U.S. Patent Publication Number 2024/0344736, published October 17, 2024, which is herein incorporated by reference in the entirety.

Each AHU device 112 may be configured to discharge cold air frontally towards the plurality of racks 108 and receive hot air from the hot aisle 107 under the ceiling. For example, as shown in FIGS. 1D-1G, the front of the plurality of racks 108 may be arranged to face the AHU devices 112. In this regard, the plurality of racks 108 and the AHU devices 112 may be arranged for direct cold air intake.

Referring to FIGS. 1D and 1F, each AHU device 112 may include an external mixing chamber 114 arranged outside the enclosure 102. For example, the AC section 202 of the AHU device 112 may include an adiabatic cooling system with external mixing chamber 114.

In embodiments, each HPD block 104 may include an exchangeable AHU device 112' that may be removed and exchanged. For example, the exchangeable AHU device 112' may be exchanged with at least one coolant distribution unit (CDU) 116. In this non-limiting example, the HPD block 104 may be equipped with pre-installed secondary fluid network infrastructure to allow for upgrading to direct-to-chip liquid cooling. The pre-installed fluid network infrastructure may be installed below the ceiling. The pre-installed fluid network infrastructure may include, but is not limited to, pipes, valves, manifolds, and other hydraulic elements. In this regard, the CDU 116 may be connected to the secondary fluid network infrastructure to provide direct-to-chip liquid cooling.

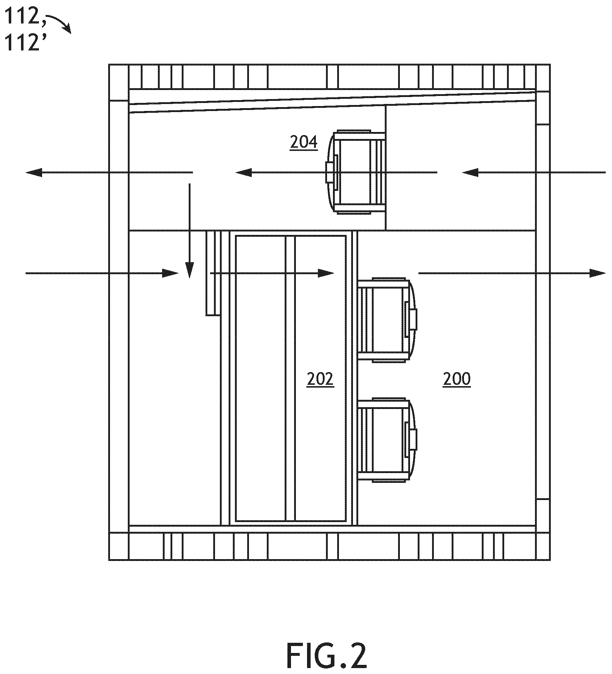

Referring to FIG. 2, each AHU device 112, 112' may include at least an air supply section 200 (or fan section), an air-conditioning (AC) section 202 (or cooling section). In some instances, the AHU device 112, 112' may further include an air return section 204. In some instances, the AHU device 112, 112' may further include the mixing chamber 114 (or section) (see FIGS. 1A-1B, 1D, 1F).

The AC section 202 may be arranged in a lower part of the AHU device 112 and be configured to discharge cold air towards the front of the plurality of racks 108. The air return section 204 may be arranged in an upper part of the AHU device 112 and be used for hot air extraction. The mixing chamber 114 (or section) may be used for mixing the fresh air from outside and hot air from the return section 204.

The AC section 202 may include, but is not limited to, a free cooling system (e.g., where the AC section 202 is empty and fresh air from outside is used for cooling), a direct evaporative cooling (DEC) system, chilled water (CW) heat exchange system, a direct expansion (DX) heat exchange system, or the like. In some embodiments, the AHU device is an exchangeable AHU device 112', such that the cooling technology of the AC section 202 may be switched out.

Aldo disclosed herein is a data center system comprising:
an enclosure including a plurality of sidewalls that define a cavity; and
a plurality of High Power Density "HPD" blocks housed within the cavity of the enclosure, the plurality of HPD blocks including at least a first HPD block and a second HPD block, wherein the first HPD block is arranged adjacent to a surface of the second HPD block, each HPD block comprising:
   at least two rack rows including at least a first rack row and a second rack row, wherein the first rack row is arranged a select distance from the second rack row to form a hot aisle, wherein each rack row includes a plurality of racks;
   at least two air handling unit "AHU" devices including at least a first AHU device arranged on a first end of the HPD block and a second AHU device arranged on a second end of the HPD block, wherein each AHU device is configured to directly distribute cool air to the plurality of racks;
   one or more busbars arranged adjacent to the first rack row and the second rack row, the one or more busbars configured to provide power to the plurality of racks of the first rack row and the second rack row, wherein the one or more busbars are arranged in the hot aisle; and
   an exchangeable AHU device arranged proximate to at least one AHU device of the at least two AHU devices, wherein the exchangeable AHU device is configured to be switched out with a coolant distribution unit to provide direct-to-chip liquid cooling.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the true spirit and scope of the subject matter described herein. Furthermore, it is to be understood that the invention is defined by the appended claims.

## Claims

1. A data center system comprising:
an enclosure including a plurality of sidewalls that define a cavity; and
one or more High Power Density "HPD" blocks housed within the cavity of the enclosure, each HPD block comprising:
at least two rack rows including at least a first rack row and a second rack row, wherein the first rack row is arranged a select distance from the second rack row to form a hot aisle, wherein each rack row includes a plurality of racks;
at least two air handling unit "AHU" devices including at least a first AHU device arranged on a first end of the HPD block and a second AHU device arranged on a second end of the HPD block, wherein each AHU device is configured to directly distribute cool air to the plurality of racks of the at least two rack rows; and
one or more busbars arranged adjacent to the first rack row and the second rack row, the one or more busbars configured to provide power to the plurality of racks of the first rack row and the second rack row, wherein the one or more busbars are arranged in the hot aisle.

2. The data center system of claim 1, wherein each HPD block further comprises:
an exchangeable AHU device arranged proximate to at least one AHU device of the at least two AHU devices, wherein the exchangeable AHU device is configured to be switched out with a coolant distribution unit to provide direct-to-chip liquid cooling.

3. The data center system of claim 1 or 2, wherein the one or more busbars are installed in a ceiling of the enclosure within the hot aisle.

4. The data center system of any preceding claim, wherein the one or more busbars include a single busbar arranged between the first rack row and the second rack row, wherein the single busbar is configured to provide power to the plurality of racks in the first rack row and the plurality of racks in the second rack row.

5. The data center system of any preceding claim, wherein the one or more busbars include a set of busbars, wherein the set of busbars include at least a first busbar arranged proximate to the first rack row and a second busbar arranged proximate to the second rack row, wherein the first busbar is configured to provide power to the plurality of racks in the first rack row and the second busbar is configured to provide power to the plurality of racks in the second rack row.

6. The data center system of any preceding claim, wherein the one or more busbars include one or more tap-off boxes.

7. The data center system of any preceding claim, wherein the first rack row is arranged parallel to the second rack row.

8. The data center system of any preceding claim, wherein the plurality of racks includes data center support equipment, wherein the data center support equipment includes at least one of one or more high-performance servers, one or more graphic processing units, one or more power management systems, or one or more cooling systems.

9. The data center system of any preceding claim, wherein each AHU device comprises:
an air supply section; and
a cooling section.

10. The data center system of claim 9, wherein each AHU device further comprises:
an air return section, and/or
a mixing section.

11. A High Power Density "HPD" block system comprising:
at least two rack rows including at least a first rack row and a second rack row, wherein the first rack row is arranged a select distance from the second rack row to form a hot aisle, wherein each rack row includes a plurality of racks;
at least two air handling unit "AHU" devices including at least a first AHU device arranged on a first end of the HPD block and a second AHU device arranged on a second end of the HPD block, wherein each AHU device is configured to direct cool air to the plurality of racks; and
one or more busbars arranged adjacent to the first rack row and the second rack row, the one or more busbars configured to provide power to the plurality of racks of the first rack row and the second rack row, wherein the one or more busbars are arranged in the hot aisle.

12. The HPD block system of claim 11, wherein each HPD block further comprises:
an exchangeable AHU device arranged proximate to at least one AHU device of the at least two AHU devices, wherein the exchangeable AHU device is configured to be switched out with a coolant distribution unit to provide direct-to-chip liquid cooling.

13. The HPD block system of claim 11 or 12, wherein the one or more busbars are installed in a ceiling of an enclosure within the hot aisle, and/or
wherein the one or more busbars include a single busbar arranged between the first rack row and the second rack row, wherein the single busbar is configured to provide power to the plurality of racks in the first rack row and the plurality of racks in the second rack row.

14. The HPD block system of any of claims 11 to 13, wherein the one or more busbars include a set of busbars, wherein the set of busbars include at least a first busbar arranged proximate to the first rack row and a second busbar arranged proximate to the second rack row, wherein the first busbar is configured to provide power to the plurality of racks in the first rack row and the second busbar is configured to provide power to the plurality of racks in the second rack row, and/or
wherein the one or more busbars include one or more tap-off boxes.

15. The HPD block system of any of claims 11 to 14, wherein the first rack row is arranged parallel to the second rack row, and/or
wherein the plurality of racks includes data center support equipment, wherein the data center support equipment includes at least one of one or more high-performance servers, one or more graphic processing units, one or more power management systems, or one or more cooling systems.
